# EUROPÄISCHE PATENTSCHRIFT

(11) **EP 2 388 909 B1**
(45) Veröffentlichungstag und Bekanntmachung des Hinweises auf die Patenterteilung: **06.06.2018**
(21) Anmeldenummer: 11161278.4
(22) Anmeldetag: 06.04.2011
(51) Int. Cl.: H03B 21/01

(54) **Signalgenerator mit digitaler Zwischenfrequenz und digitaler Frequenzfeineinstellung**
Signal generator with digital intermediate frequency and digital frequency adjustment
Générateur de signal doté d'une fréquence intermédiaire numérique et d'un réglage précis de fréquence numérique

(30) Priorität: 18.05.2010 DE 102010020909; 19.07.2010 DE 102010027566
(43) Veröffentlichungstag der Anmeldung: 23.11.2011
(73) Patentinhaber: Rohde & Schwarz GmbH & Co. KG, 81671 München (DE)
(72) Erfinder: Ehrlich, Stefan, 81543 München (DE)
(74) Vertreter: Körfer, Thomas

(56) Entgegenhaltungen:
- EP-A1- 1 811 650
- US-A1- 2004 072 547
- US-B1- 6 334 051
- US-B1- 6 668 024

## Beschreibung

Die Erfindung betrifft einen mehrstufigen Signalgenerator mit digital erzeugter Zwischenfrequenz, insbesondere für digital modulierte Signale.

Sender, bei welchen die Ausgangsfrequenz nicht lediglich in einem festen, groben Kanalraster einstellbar ist, sondern bei welchen eine sehr kleine Schrittweite, wie z.B. 1Hz, erreicht werden kann, weisen üblicherweise einen Synthesizer mit fester Referenzfrequenz und eine Fraktional-N-PLL oder einen Synthesizer mit variabler Referenzfrequenz und eine Integer-N-PLL auf. So zeigt die DE 199 37 608 A1 eine solche Realisierungen eines Signalgenerators. Sowohl Fraktional-N-PLL-Oszillatoren wie auch Synthesizer mit variabler Referenzfrequenz erfordern dabei jedoch einen hohen Entwicklung- und Herstellungsaufwand. Darüber hinaus weisen die resultierenden Schaltungen eine große Baugröße auf. Ein nicht optimales Phasenrauschen und geringer Nebenlinienabstand der bekannten Signalmodulatoren mit Fraktional-N-PLL sind weitere Nachteile.

Das Dokument EP 1 811 650 A1 zeigt ein Verfahren zur fein-Einstellung der Frequenz eines Ausgangssignals eines Signalgenerators und einen entsprechenden Signalgenerator. Aus einem digitalen I-Signal und einem digitalen Q-Signal wird durch digitale Modulation mit einem ersten Oszillatorsignal ein I/Q Basisbandsignal erzeugt. Dieses wird in ein analoges Basisbandsignal gewandelt. Das analoge Basisbandsignal wird mit einem Oszillatorsignal gemischt. Anschließend werden die I-Komponente und die Q-Komponente zu einem Ausgangssignal summiert. Das Oszillatorsignal wird dabei durch einen Integer-N-Oszillator erzeugt.

Das Dokument US 6,668,024 B1 zeigt einen Sender für Hochfrequenzsignale. Auch hier wird ein digitales I/Q-Signal digital durch Mischen mit einem ersten Oszillatorsignal moduliert und anschließend zu einem analogen Signal umgewandelt. Nach einer Filterung erfolgt eine Mischung mit einem Oszillatorsignal. Nach Addierung der resultierenden Teilsignale und einer optionalen erneuten Filterung wird ein Ausgangssignal ausgegeben.

Das Dokument US 6,334,051 B1 zeigt einen Empfänger für Hochfrequenzsignale. Dabei wird das empfangene Signal durch Mischung mit einem phasenversetzten Oszillatorsignal in ein I/Q Zwischenfrequenzsignal gewandelt. Anschließend wird es durch erneute Mischung mit einem zweiten Oszillatorsignal und eine anschließende Summierung der I-Komponente und Q-Komponente in ein Empfangssignal gewandelt.

Der Erfindung liegt die Aufgabe zugrunde, einen Signalgenerator zu schaffen, welcher unter Beibehaltung einer feinen Frequenzauflösung lediglich einen geringen Herstellungsaufwand verursacht und ein geringes Phasenrauschen aufweist.

Die Aufgabe wird erfindungsgemäß durch die Merkmale des unabhängigen Anspruchs 1 gelöst. Vorteilhafte Weiterbildungen sind Gegenstand der hierauf rückbezogenen Unteransprüche.

Nachfolgend wird die Erfindung, in der ein vorteilhaftes Ausführungsbeispiel der Erfindung dargestellt ist, beispielhaft beschrieben. In der Zeichnung zeigen:
- Fig. 1: ein exemplarischer Signalgenerator, und
- Fig. 2: ein Ausführungsbeispiel des erfindungsgemäßen Signalgenerators.

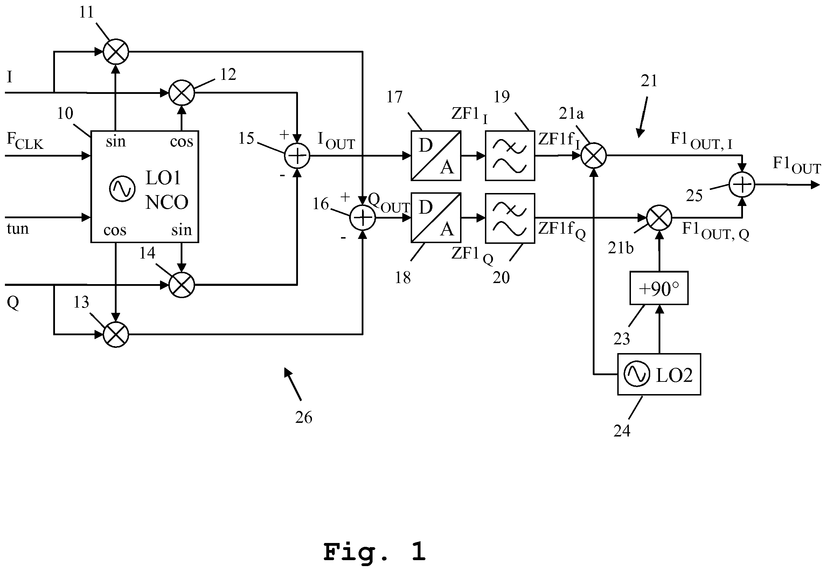

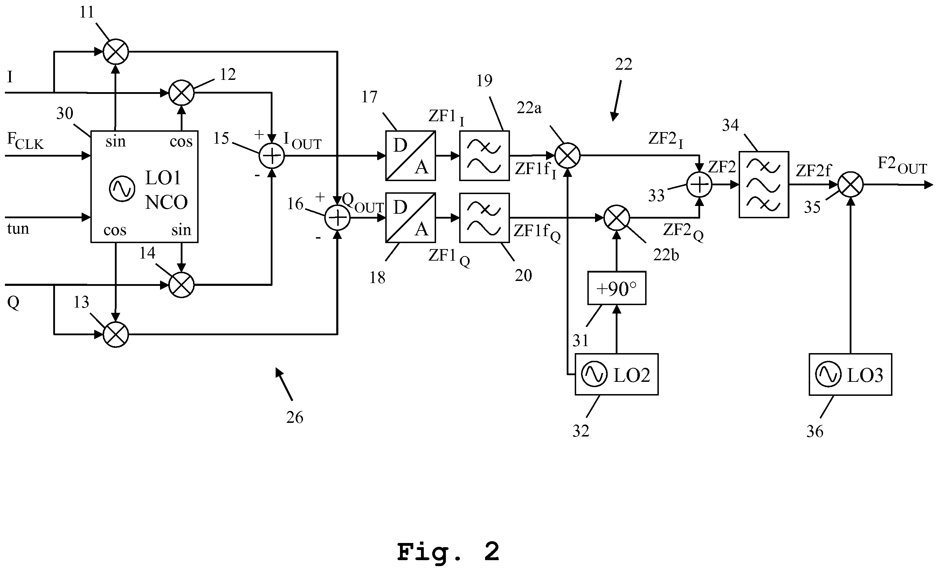

Zunächst wird die der Erfindung zu Grunde liegende Problematik erläutert. Mittels Fig. 1, 2 werden der Aufbau und die Funktionsweise verschiedener Formen eines exemplarischen Signalgenerators und des erfindungsgemäßen Signalgenerators gezeigt. Identische Elemente wurden in ähnlichen Abbildungen z.T. nicht wiederholt dargestellt und beschrieben.

Bei herkömmlichen Sendern für I/Q-modulierte Signale werden die I/Q-Signale im Basisband bereitgestellt. Anschließend erfolgt herkömmlicherweise eine Frequenzumsetzung mittels eines Mischers. Die Frequenz des Ausgangssignals wird dabei durch die Oszillatorfrequenz, mit welcher das Basisbandsignal gemischt wird, bestimmt. Um so eine fein einstellbare Frequenz des Ausgangssignals zu erhalten, ist es notwendig, das Oszillatorsignal sehr genau in seiner Frequenz zu justieren. Hierfür kann beispielsweise ein Fraktional-N-PLL Oszillator eingesetzt werden. Nachteilhaft hieran ist jedoch, dass Fraktional-N-PLL Oszillatoren sehr aufwendig in der Herstellung und Entwicklung sind und einen großen Bauraum einnehmen. Darüber hinaus weisen sie ein nicht optimales Phasenrauschen und geringen Nebenlinienabstand auf. Alternativ kann als Oszillatorsignal eine direkte digitale Synthese (DDS) herangezogen werden. Diese ist jedoch in ihrer maximalen Frequenz stark eingeschränkt. Sollen mittels direkter digitaler Synthese hohe Frequenzen erreicht werden, ist ein mehrstufiger Aufbau notwendig. Auch dieser Aufbau erfordert einen hohen Aufwand und Raumbedarf.

Die vorliegende Erfindung ermöglicht die Realisierung von Sendern, deren Ausgangsfrequenz in sehr kleinen Frequenzschritten, z.B. unter 1Hz, möglich ist. Dabei sind alle beteiligten Synthesizer nach dem Prinzip der Integer (Ganzzahl)-N-PLL mit fester Referenzfrequenz aufgebaut. Die Feineinstellung der Frequenz erfolgt auf einer digitalen Zwischenfrequenz. Das Prinzip ist sowohl auf Sender mit Direktmodulation bzw. Direktumsetzung als auch auf Sender mit Zwischenfrequenz und anschließender Frequenzumsetzung mittels Mischer anwendbar.

Fig. 1 zeigt einen exemplarischen Signalgenerator. Ein Oszillator 10 ist mit einem I/Q-Modulator 26 verbunden. Der I/Q-Modulator 26 besteht dabei aus vier Mischern 11, 12, 13, 14 und zwei Addierern 15, 16. Der I/Q-Modulator 26 ist mit zwei Digital/Analog-Wandlern 17, 18 verbunden. Diese sind wiederum mit Filtern 19, 20 verbunden. Die Filter 19, 20 sind mit einem Mischer 21, bestehend aus zwei Teilmischern 21a, 21b verbunden. Die Teilmischer 21a, 21b sind weiterhin verbunden mit einem zweiten Oszillator 24. Der erste Teilmischer 21a ist dabei direkt mit dem zweiten Oszillator 24 verbunden. Der zweite Teilmischer 21b ist über einen Phasenschieber 23 mit dem Oszillator 24 verbunden. Die Ausgänge der Teilmischer 21a, 21b sind mit einem Addierer 25 verbunden.

Bei dem Oszillator 10 handelt es sich um einen nummerisch gesteuerten Oszillator. An einem ersten Eingang wird ein Taktsignal F_{CLK} eingespeist. Es weist eine feste Frequenz von 1MHz - 1GHz, bevorzugt von 100MHz - 500MHz,
beispielsweise 200MHz auf. An einem zweiten Eingang wird ein digitales Steuersignal tune eingespeist. Das Steuersignal tune stellt dabei die Ausgangsfrequenz des ersten Oszillators 10 ein. Der Oszillator 10 verfügt dabei über vier Ausgänge, welche das erzeugte Signal bereitstellen. Zwei Ausgänge sin stellen dabei direkt das erzeugte Signal bereit. Die anderen beiden Ausgänge cos stellen dabei ein um 90° phasenverschobenes Signal bereit.

Die Ausgänge sin des ersten Oszillators 10 sind dabei mit den Mischern 11, 14 des I/Q-Modulators 14 verbunden. Die Ausgänge cos des ersten Oszillators 10 sind dabei mit den Mischern 12, 13 des I/Q-Modulators 26 verbunden. Den Mischern 11, 12 wird jeweils an einem weiteren Eingang ein digitales in Phase-Signal I zugeführt. Dieses Signal wird mit dem Oszillatorsignal, bzw. dem um 90° phasenverschobenen Oszillatorsignal, gemischt. Analog wird den Mischern 13, 14 das Oszillatorsignal, bzw. das um 90° phasenverschobene Oszillatorsignal zugeführt. Über jeweils einen weiteren Eingang wird den Mischern 13, 14 ein Quadratur-Signal Q zugeführt. Wie auch die Mischer 11, 12 mischen die Mischer 13, 14 das Quadratur-Signal mit dem Oszillatorsignal bzw. dem um 90° phasenverschobenen Oszillatorsignal.

Anschließend subtrahiert der Addierer 15 das Ausgangssignal des Mischers 14 von dem Ausgangssignal des Mischers 12. Gleichzeitig addiert der Addierer 16 das Ausgangssignal des Mischers 13 zu dem Ausgangssignal des Mischers 11. Die resultierenden Signale I_{OUT} und Q_{OUT} werden an die Digital/Analog-Wandler 17, 18 übertragen und von diesen in analoge Signale ZF1_{I}, und ZF1_{Q} gewandelt. Diese Signale weisen ein einzelnes Seitenband und keinen Träger auf. Ihre Frequenzen betragen 0MHz bis 200MHz, bevorzugt 0MHz bis 100MHz, beispielsweise 47,5MHz bis 52,5MHz. Die Frequenzen der Signale sind dabei identisch. Sie sind mit einer Schrittgröße von 10µHz bis 1mHz, bevorzugt von 50µHz bis 200µHz, beispielsweise von 100µHz, durch Veränderung des digitalen Signals tune einstellbar. Darüber hinaus weisen die Signale ZF1_{I}, und ZF1_{Q} ungewollte Oberwellen und Aliasprodukte des Abtastvorgangs auf.

Die Signale ZF1_{I}, und ZF1_{Q} werden an die Filter 19, 20 übertragen und von diesen zu den Signalen ZF1f_{I} und ZF1f_{Q} gefiltert. Dabei werden unerwünschte nichtideale Ausgangssignale der D/A-Wandler 17, 18 gefiltert. Insbesondere die Oberwellen und Aliasprodukte werden von den Filtern 19, 20 entfernt.

Die resultierenden Signale ZF1f_{I}, ZF1f_{Q} werden jeweils den Eingängen der Teilmischer 21a, 21b zugeführt. Die Teilmischer 21a, 21b mischen diese Signale ZF1f_{I}, ZF1f_{Q} mit dem Oszillatorsignal bzw. dem um 90° phasenverschobenen Oszillatorsignal zu den Signalen F1_{OUT, I} und F1_{OUT,Q}. Bei dem Oszillator 24 handelt es sich um einen Integer-N-PLL-Oszillator. D.h. der Oszillator 24 kann nur in groben Schritten in seiner Ausgangsfrequenz geregelt werden, da der Teilungsfaktor nur ganzzahlig ist. Das Oszillatorsignal weist dabei eine von 400MHz bis 3,0GHz, bevorzugt von 800MHz bis 2,4GHz, beispielsweise von 952,5MHz bis 1947,5MHz einstellbare Ausgangsfrequenz auf. Diese Ausgangsfrequenz ist dabei mit einer festen Schrittweite von 1MHz bis 20MHz, bevorzugt von 3MHz bis 10MHz, beispielsweise von 5MHz, einstellbar.

Abschließend werden die Signale F1_{OUT, I}, F1_{OUT, Q} von dem Addierer 25 zu dem Ausgangssignal FL_{OUT} addiert. Die Einstellung der Frequenz des Ausgangssignals F1_{OUT} erfolgt somit durch den Oszillator 10 und den Oszillator 24. Die niederfrequenten Basisbandsignale I_{OUT}, Q_{OUT} werden mit den in ihrer Frequenz sehr fein einstellbaren Signalen des Oszillators 10 gemischt. Das modulierte, digitalisierte und gefilterte Signal ZF1f_{I/Q} wird mit dem in seiner Frequenz grob einstellbaren Oszillatorsignal gemischt und somit in einen hohen Frequenzbereich umgesetzt.

Etwas nachteilhaft bei dem in Fig. 1 gezeigten Ausführungsbeispiel ist noch, dass die Frequenz des Ausgangssignals F_{OUT} sehr nahe bei der Frequenz des Oszillatorsignals liegt. Das Oszillatorsignal schlägt hier in das Ausgangssignal F_{OUT} durch. Eine Filterung ist sehr schwierig. Vorteilhaft ist jedoch die hohe Flexibilität der Frequenz des Ausgangssignals F1_{OUT}.

Dieses Problem wird durch das, in Fig. 2 dargestellte Ausführungsbeispiel des erfindungsgemäßen Signalgenerators behoben. Es werden lediglich Unterschiede zu dem Aufbau nach Fig. 1 dargestellt. Der Mischer 21 aus Fig. 1 ist hier durch den Mischer 22 ersetzt. Auch er besteht aus zwei Teilmischern 22a und 22b. Die zweiten Eingänge der Teilmischer 22a, 22b sind hier mit einem Oszillator 32 direkt bzw. über einen Phasenschieber 31 verbunden. Die Ausgänge der Teilmischer 22a, 22b sind mit einem Addierer 33 verbunden. Der Ausgang des Addierers 33 ist mit einem Bandpassfilter 34 verbunden. Der Ausgang des Bandpassfilters 34 ist mit einem weiteren Mischer 35 verbunden. Ein zweiter Eingang des weiteren Mischers 35 ist mit einem Oszillator 36 verbunden.

Die D/A (Digital/Analog)-gewandelten und gefilterten Signale ZF1f_{I}, ZF1f_{Q} weisen hier eine über das digitale Signal tune einstellbare Frequenz von 30 bis 200MHz, bevorzugt von 40 bis 130MHz, beispielsweise von 47,5 bis 52,5MHz auf. Die feste Schrittweite der Einstellung der Frequenz beträgt dabei 1MHz bis 20MHz, bevorzugt von 3MHz bis 10MHz, beispielsweise 5MHz.

Die Signale ZF1f_{I}, ZF1f_{Q} werden von den Teilmischern 22a, 22b mit dem Signal des Oszillators 32 bzw. dem um 90° phasenverschobenen Signal des Oszillators 32 gemischt. Der Oszillator 32 ist dabei ein Integer-N-PLL-Oszillator mit fester Frequenz. Das Oszillatorsignal weist dabei eine feste Frequenz von 500MHz bis 2,0GHz, bevorzugt von 700MHz bis 1,4GHz, beispielsweise von 950MHz auf.

Durch diese Mischung erfolgt eine Umsetzung auf eine zweite Zwischenfrequenz. Die erzeugten Teilsignale ZF1_{I}, ZF1_{Q} werden von dem Addierer 33 zu dem Zwischenfrequenzsignal ZF2 addiert. Dieses Signal weist jedoch nach wie vor ein unerwünschtes Seitenband und einen Restträger auf. Diese entstehen hier durch Asymmetrien und einen DC-Offset. Sie werden durch den Bandpassfilter 34 entfernt, was für die Signalqualität und die spektrale
Reinheit des Transmitters sehr vorteilhaft ist. Das resultierende Signal ZF2f wird von dem Mischer 35 mit einem Trägersignal (Oszillatorsignal), welches von dem Oszillator 36 erzeugt wird, gemischt. Der Oszillator ist dabei ein Integer-N-PLL-Oszillator mit in einem groben Raster einstellbarer Ausgangsfrequenz. Die Frequenz des Oszillators 36 beträgt dabei 500MHz bis 4,0GHz, bevorzugt von 1,0GHz bis 3,0GHz, beispielsweise von 2002,5MHZ bis 2997,5MHz. Die Frequenz ist dabei mit einer festen Schrittweite von 1MHz bis 20MHz, bevorzugt von 3MHz bis 10MHz, beispielsweise von 5MHz einstellbar.

Die Frequenz des Ausgangssignals F2_{OUT} wird dabei durch Einstellung der Ausgangsfrequenz des Oszillators 30 und des Oszillators 36 eingestellt. Die Grobeinstellung der Ausgangsfrequenz erfolgt dabei durch den Oszillator 36, während die Feineinstellung durch den Oszillator 30 erfolgt.

Alternativ kann auch der Oszillator 36 mit in einem groben Raster einstellbarer Ausgangsfrequenz aufgebaut sein. Bei dieser alternativen Ausführung wird gleichzeitig ein umschaltbarer Bandpassfilter 34 eingesetzt. D.h. durch Einstellung der Ausgangsfrequenz des Oszillators 32 und entsprechender Einstellung des Frequenzbereichs des Bandpassfilters 34 wird eine Erweiterung des Frequenzbereichs des Systems erreicht.

Vorteilhaft bei diesem Ausführungsbeispiel ist die gute Unterdrückung des Trägers in dem Ausgangssignal F2_{OUT}. Diese ist möglich, weil die Frequenz des Oszillatorsignals weit von der Frequenz des Ausgangssignals entfernt liegt. Nachteilhaft ist hier jedoch der eingeschränkte Frequenzbereich des Ausgangssignals F2_{OUT}. Ein weiterer Vorteil ist die Filterung von Trägerrest und unerwünschtem Seitenband durch das Bandpassfilter 34.

Die Erfindung ist nicht auf das dargestellte Ausführungsbeispiel beschränkt. Wie bereits erwähnt, können unterschiedliche Frequenzkonzepte eingesetzt werden. Eine Anwendung des Signalgenerators kann beispielsweise im Bereich Hochleistungssender und Test-Modulatoren erfolgen. Alle vorstehend beschriebenen Merkmale oder in den Figuren gezeigten Merkmale sind im Rahmen der Erfindung beliebig vorteilhaft miteinander kombinierbar.

## Patentansprüche

1. Signalgenerator mit einem ersten Oszillator (30), einem zweiten Oszillator (36) und einem ersten Mischer (35), wobei der erste Oszillator (30) ein erstes Oszillatorsignal erzeugt und zumindest mittelbar an den ersten Mischer (35) leitet,
wobei der zweite Oszillator (36) ein zweites Oszillatorsignal erzeugt und an den ersten Mischer (35) leitet, und
wobei der erste Mischer (35) das zweite Oszillatorsignal und das mittelbar an den ersten Mischer (35) geleitete erste Oszillatorsignal mischt,
wobei der erste Oszillator (30) ein numerisch gesteuerter Oszillator ist,
wobei der zweite Oszillator (36) ein einstellbarer Oszillator mit fester Schrittweite ist,
wobei der Signalgenerator über einen zweiten Mischer (22) bestehend aus zwei zweiten Teilmischern (22a, 22b) verfügt,
wobei der Signalgenerator über einen dritten Oszillator (32) verfügt,
wobei der dritte Oszillator (32) ein drittes Oszillatorsignal, bestehend aus zwei um 90° phasenverschobenen dritten Oszillatorteilsignalen erzeugt, wobei die zweiten Teilmischer (22a, 22b) Filter-Teilsignale (ZF1f_{I}, ZF1f_{Q}) mit den dritten Oszillatorteilsignalen mischen,
wobei der Signalgenerator über einen Addierer (33) verfügt, welcher Ausgangssignale (ZF2_{I}, ZF2_{Q}) der zweiten Teilmischer zu einem Zwischenfrequenzsignal (ZF2) addiert, wobei der erste Mischer (35) das Zwischenfrequenzsignal (ZF2) mit dem zweiten Oszillatorsignal zu einem Ausgangssignal (F2_{OUT}) mischt,
wobei der Signalgenerator weiterhin über einen I/Q-Modulator verfügt,
wobei der erste Oszillator (30) zwei um 90° phasenverschobene Teilsignale ausgibt, und
wobei der 1/Q-Modulator die beiden Teilsignale (sin, cos) des ersten Oszillators zu zwei Modulator-Teilsignalen (I_{OUT}, Q_{OUT}) moduliert,
wobei der Signalgenerator weiterhin über ein erstes Filter (19, 20), bestehend aus zwei Teilfiltern (19, 20), verfügt,
wobei der I/Q-Modulator die zwei erzeugten Modulator-Teilsignale (I_{OUT}, Q_{OUT}) den beiden Teilfiltern (19, 20) zuführt,
wobei die beiden Teilfilter (19, 20) die beiden Modulator-Teilsignale (I_{OUT}, Q_{OUT}) zu den zwei Filter-Teilsignalen (ZF1f_{I}, ZF1f_{Q}) filtern.

2. Signalgenerator nach Anspruch 1,
**dadurch gekennzeichnet,**
**dass** der zweite Oszillator (24, 36) ein Integer-N-PLL-Oszillator ist.

3. Signalgenerator nach Anspruch 1,
**dadurch gekennzeichnet,**
**dass** der dritte Oszillator (32) ein Integer (Ganzzahl)-N-PLL-Oszillator ist, und
**dass** das dritte Oszillatorsignal eine feste Frequenz aufweist.

4. Signalgenerator nach Anspruch 1,
**dadurch gekennzeichnet,**
**dass** der dritte Oszillator (32) ein Integer (Ganzzahl)-N-PLL-Oszillator ist, und
**dass** das dritte Oszillatorsignal eine mit fester Schrittweite einstellbare Frequenz aufweist.

5. Signalgenerator nach einem der Ansprüche 1 bis 4,
**dadurch gekennzeichnet,**
**dass** der Signalgenerator weiterhin über ein zweites Filter (34) verfügt,
**dass** das zweite Filter (34) ein Bandpassfilter ist, und dass das zweite Filter (34) das Zwischenfrequenzsignal (ZF2) filtert.

6. Signalgenerator nach einem der Ansprüche 1 bis 5,
**dadurch gekennzeichnet,**
**dass** die Frequenz eines Ausgangssignals (F1_{OUT}, F2_{OUT}) zumindest durch Einstellung der Frequenz des ersten Oszillatorsignals und des zweiten Oszillatorsignals einstellbar ist.

7. Signalgenerator nach einem der Ansprüche 1 bis 6,
**dadurch gekennzeichnet,**
**dass** die Frequenz des Ausgangssignals (F1_{OUT}, F2_{OUT}) durch Einstellung der Frequenz des ersten Oszillatorsignals, des zweiten Oszillatorsignals und des dritten Oszillatorsignals einstellbar ist.

## Claims

1. Signal generator with a first oscillator (30), a second oscillator (36) and a first mixer (35),
wherein the first oscillator (30) generates a first oscillator signal and passes it at least indirectly to the first mixer (35),
wherein the second oscillator (36) generates a second oscillator signal and passes it to the first mixer (35), and
wherein the first mixer (35) mixes the second oscillator signal and the first oscillator signal passed indirectly to the first mixer (35),
wherein the first oscillator (30) is a numerically controlled oscillator,
wherein the second oscillator (36) is an adjustable oscillator with a fixed step width,
wherein the signal generator has a second mixer (22) consisting of two second part mixers (22a, 22b),
wherein the signal generator has a third oscillator (32), wherein the third oscillator (32) generates a third oscillator signal, consisting of two third oscillator part signals which are 90° out of phase,
wherein the second part mixers (22a, 22b) mix filter part signals (ZF1f_{I}, ZF1f_{Q}) with the third oscillator part signals,
wherein the signal generator has an adder (33) which adds output signals (ZF2_{I}, ZF2_{Q}) of the second part mixers to form an intermediate frequency signal (ZF2),
wherein the first mixer (35) mixes the intermediate frequency signal (ZF2) with the second oscillator signal to form an output signal (F2_{OUT}),
wherein the signal generator also has an I/Q modulator, wherein the first oscillator (30) outputs two part signals which are 90° out of phase, and
wherein the I/Q modulator modulates the two part signals (sin, cos) of the first oscillator to form two modulator part signals (I_{OUT}, Q_{OUT}),
wherein the signal generator also has a first filter (19, 20) consisting of two part filters (19, 20),
wherein the I/Q modulator feeds the two generated modulator part signals (I_{OUT}, Q_{OUT}) to the two part filters (19, 20),
wherein the two part filters (19, 20) filter the two modulator part signals (I_{OUT}, Q_{OUT}) to form the two filter part signals (ZF1f_{I}, ZF1f_{Q}).

2. Signal generator according to claim 1,
**characterised in that**
the second oscillator (24, 36) is an integer-N-PLL oscillator.

3. Signal generator according to claim 1,
**characterised in that**
the third oscillator (32) is an integer-N-PLL oscillator, and
**in that** the third oscillator signal has a fixed frequency.

4. Signal generator according to claim 1,
**characterised in that**
the third oscillator (32) is an integer-N-PLL oscillator, and
**in that** the third oscillator signal has a frequency which is adjustable with a fixed step width.

5. Signal generator according to one of claims 1 to 4,
**characterised in that**
the signal generator also has a second filter (34),
**in that** the second filter (34) is a bandpass filter, and **in that** the second filter (34) filters the intermediate frequency signal (ZF2).

6. Signal generator according to one of claims 1 to 5,
**characterised in that**
the frequency of an output signal (F1_{OUT}, F2_{OUT}) is adjustable at least by adjusting the frequency of the first oscillator signal and the second oscillator signal.

7. Signal generator according to one of claims 1 to 6,
**characterised in that**
the frequency of the output signal (F1_{OUT}, F2_{OUT}) is adjustable by adjusting the frequency of the first oscillator signal, the second oscillator signal and the third oscillator signal.

## Revendications

1. Générateur de signaux comprenant un premier oscillateur (30), un deuxième oscillateur (36) et un premier mélangeur (35),
le premier oscillateur (30) générant un premier signal d'oscillateur et le dirigeant au moins indirectement vers le premier mélangeur (35),
le deuxième oscillateur (36) générant un deuxième signal d'oscillateur et le dirigeant vers le premier mélangeur (35), et
le premier mélangeur (35) mélangeant le deuxième signal d'oscillateur et le premier signal d'oscillateur dirigé indirectement vers le premier mélangeur (35),
le premier oscillateur (30) étant un oscillateur à commande numérique,
le deuxième oscillateur (36) étant un oscillateur réglable à incrément fixe,
le générateur de signaux disposant d'un deuxième mélangeur (22) constitué de deux deuxièmes parties de mélangeur (22a, 22b),
le générateur de signaux disposant d'un troisième oscillateur (32),
le troisième oscillateur (32) générant un troisième signal d'oscillateur, constitué de deux troisièmes parties de signal d'oscillateur déphasées de 90°,
les deuxièmes parties de mélangeur (22a, 22b) mélangeant des parties de signal de filtre (ZF1f_{I}, ZF1f_{Q}) aux troisièmes parties de signal d'oscillateur,
le générateur de signaux disposant d'un additionneur (33), lequel additionne les signaux de sortie (ZF2_{I}, ZF2_{Q}) des deuxièmes parties de mélangeur de manière à obtenir un signal de fréquence intermédiaire (ZF2),
le premier mélangeur (35) mélangeant le signal de fréquence intermédiaire (ZF2) au deuxième signal d'oscillateur de manière à obtenir un signal de sortie (F2_{OUT}),
le générateur de signaux disposant en outre d'un modulateur I/Q,
le premier oscillateur (30) délivrant deux parties de signal déphasées de 90°, et
le modulateur I/Q modulant les deux parties de signal (sin, cos) du premier oscillateur de manière à obtenir deux parties de signal de modulateur (I_{OUT}, Q_{OUT}),
le générateur de signaux disposant en outre d'un premier filtre (19, 20), constitué de deux parties de filtre (19, 20),
le modulateur I/Q amenant les deux parties de signal de modulateur (I_{OUT}, Q_{OUT}) générées aux deux parties de filtre (19, 20),
les deux parties de filtre (19, 20) filtrant les deux parties de signal de modulateur (I_{OUT}, Q_{OUT}) de manière à obtenir les deux parties de signal de filtre (ZF1f_{I}, ZF1f_{Q}).

2. Générateur de signaux selon la revendication 1,
**caractérisé en ce que**
le deuxième oscillateur (24, 36) est un oscillateur à N-entier-boucles à verrouillage de phase.

3. Générateur de signaux selon la revendication 1,
**caractérisé en ce que**
le troisième oscillateur (32) est un oscillateur à N-entier-boucles à verrouillage de phase, et
**en ce que** le troisième signal d'oscillateur présente une fréquence fixe.

4. Générateur de signaux selon la revendication 1,
**caractérisé en ce que**
le troisième oscillateur (32) est un oscillateur à N-entier-boucles à verrouillage de phase, et
**en ce que** le troisième signal d'oscillateur présente une fréquence réglable à incrément fixe.

5. Générateur de signaux selon l'une quelconque des revendications 1 à 4,
**caractérisé en ce que**
le générateur de signaux dispose en outre d'un deuxième filtre (34),
**en ce que** le deuxième filtre (34) est un filtre passe-bande, et
**en ce que** le deuxième filtre (34) est un signal à fréquence intermédiaire (ZF2).

6. Générateur de signaux selon l'une quelconque des revendications 1 à 5,
**caractérisé en ce que**
la fréquence d'un signal de sortie (F1_{OUT}, F2_{OUT}) peut être réglée au moins par réglage de la fréquence du premier signal d'oscillateur et du deuxième signal d'oscillateur.

7. Générateur de signaux selon l'une quelconque des revendications 1 à 6,
**caractérisé en ce que**
la fréquence du signal de sortie (F1_{OUT}, F2_{OUT}) peut être réglée par réglage de la fréquence du premier signal d'oscillateur, du deuxième signal d'oscillateur et du troisième signal d'oscillateur.
